(19) Europäisches Patentamt
European Patent Office
Office européen des brevets

(11) **EP 4 715 399 A1**

(12) **EUROPEAN PATENT APPLICATION**

(43) Date of publication:
25.03.2026 Bulletin 2026/13

(21) Application number: 25203757.7

(22) Date of filing: **22.09.2025**

(51) International Patent Classification (IPC):
**G01R 15/18** (2006.01)    **G01R 19/32** (2006.01)

(52) Cooperative Patent Classification (CPC):
**G01R 15/181; G01R 19/32**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **24.09.2024 US 202463698411 P**

(71) Applicant: **Analog Devices International Unlimited Company Co. Limerick (IE)**

(72) Inventors:
• **Hurwitz, Jonathan Ephraim David Limerick (IE)**
• **Brown, Christopher Thomas Limerick (IE)**

(74) Representative: **Horler, Philip John Withers & Rogers LLP 2 London Bridge London SE1 9RA (GB)**

(54) **CURRENT MEASUREMENT USING A DI/DT CURRENT SENSOR**

(57) The present disclosure relates to a current measurement system and method that uses a rate of change of current sensor, such as a Rogowski Coil. The system comprises a rate of change of current sensor and a coupled measurement circuit. A temperature response of at least part of the signal processing circuitry is set so as to reduce or eliminate changes in the signal gain of the system caused by temperature changes.

## Description

### Technical Field

The present disclosure relates to the measurement of current using rate of change of current sensors (di/dt sensors), such as Rogowski coils.

### Background

Currents may be measured using current sensors coils, such as rate of change of current sensors (di/dt sensors) such as Rogowski coils. These coils measure the rate of change or differential of the current in a conductor under test. An integrator may be coupled to the output of the current sensor and used to determine the current drawn.

The signal gain of such coils can be sensitive to changes in temperature, such that as the temperature of the coil increases (for example, because it is in a warmer environment), its signal gain changes. Typically, the coil signal gain increases with increased temperature, which means that for the same current in the conductor under test, the signal output from the coil increases as temperature increases. This may reduce the accuracy of current measurement.

### Summary

In a first aspect of the disclosure there is provided a method of setting a temperature response of a current measurement system, wherein the current measurement system comprises: a current sensing coil for sensing a current in a conductor; and signal processing circuitry coupled to the current sensing coil for determining a measurement of the current in the conductor, the method comprising: setting a temperature response of at least part of the signal processing circuitry based on at least one of: an impedance of the current sensing coil; an input impedance of the signal processing circuitry to which the current sensing coil is coupled; a temperature dependent signal gain of the current measurement system.

In a second aspect of the disclosure there is provided a current measurement system comprising: a current sensing coil comprising an opening suitable for a conductor to pass through, wherein the coil is suitable for sensing current in the conductor passing through the opening; and signal processing circuitry coupled to the current sensing coil for determining a measurement of the current, wherein the signal processing circuitry is configured for setting a temperature response of at least part of the signal processing circuitry based on at least one of: an impedance of the current sensing coil; an input impedance of the signal processing circuitry to which the current sensing coil is coupled; a temperature dependency of a signal gain of the current measurement system.

In a third aspect of the disclosure there is provided a signal processing circuitry for use in measuring a current using a current sensing coil, the signal processing circuitry comprising: one or more input terminals for coupling to a current sensing coil; an analog to digital converter, ADC, for digitally converting an analog signal that is dependent on a signal at the one or more input terminals; and a reference voltage circuit coupled to the ADC so as to supply a reference voltage to the ADC, wherein the reference voltage circuit is configured to be trimable across a predetermined range of values so as to trim the reference voltage supplied to the ADC and set a temperature response of the signal processing circuitry, wherein the predetermined range of values is set to support a range of current sensing coil impedances.

### Drawings

Aspects of the disclosure are described, by way of example only, with reference to drawings in which:

Figure 1 is a diagram of a current sensor coil;
Figures 2a and 2b represent inductors as the equivalent component of a measurement coil;
Figure 3 shows a schematic circuit representation of a coil and an input stage of signal processing circuitry;
Figure 4 shows an example current measurement system in accordance with an aspect of the present disclosure;
Figure 5 shows an example method of setting the temperature response of the current measurement system of Figure 4;
Figure 6A shows an example system that can be used for tamper/failure detection in accordance with an aspect of the present disclosure;
Figure 6B shows an example schematic for understanding the operation of the system of Figure 6A;
Figure 7 shows a further example system that can be used for tamper/failure detection in accordance with an aspect of the present disclosure;
Figure 8 shows a further example system that can be used for tamper/failure detection in accordance with an aspect of the present disclosure;

Figure 9 shows a further example system that can be used for tamper/failure detection in accordance with an aspect of the present disclosure;

Figure 10 shows an example method by which a fault/tamper may be detected in accordance with an aspect of the present disclosure; and

Figure 11 shows an example utility meter in accordance with an aspect of the present disclosure;

## Detailed description

This disclosure presents techniques to address current measurement inaccuracies caused by the effects of temperature changes on current sensing coils, such as di/dt sensors like Rogowski coils. Current sensing coils are usually coupled to signal processing circuitry that uses the signal output by the current sensing coil to determine a measurement of the current in the conductor that passes through the current sensing coil.

The inventors have recognised that the impedance of the current sensing coil itself and the input impedance of signal processing circuit also have a temperature dependency. The impedance of the current sensing coil and the input impedance of the signal processing circuit together form a potential divider that has a signal gain that is dependent on the ratio of the impedance of the current sensing coil and the input impedance of the signal processing circuit. Based on this recognition, the inventors have determined that by setting the impedance of the current sensing coil and the input impedance of the signal processing circuit to appropriate values, changes in their ratio caused by a change in temperature may be such that the gain of the potential divider moves in the opposite direction to the gain of the current sensing coil as temperature changes. To put it another way, if the current sensing coil gain increases as temperature increases, the impedance of the current sensing coil and the input impedance of the signal processing circuit could be set so that the gain of the potential divider decreases as temperature, so that the two gain changes cancel each other out.

However, the inventors have identified that there are limitations on the impedances at which the current sensing coil may be, as a result of physical limitations caused by coil size and thickness of the conductor making up the coil. As a result, it may be very difficult to set current e impedance of the current sensing coil and the input impedance of the signal processing circuit in a way that results in a complete cancellation in gain changes of the current sensing coil and the potential divider. Consequently, the overall signal gain of the current sensing coil and the signal processing circuitry may still have a temperature dependence.

In order to reduce or eliminate the temperature dependency of the overall system gain, the inventors have devised techniques whereby a temperature response of the signal processing circuit is set based on the impedance of the current sensing coil and/or based on the input impedance of the signal processing circuitry. Consequently, it is not necessary for the impedance of the current sensing coil and the input impedance of the signal processing circuitry to be set so that the temperature dependency of the potential divider gain exactly inversely matches that of the temperature dependence of the current sensing coil gain. As a result, more accurate current measurement may be achieved, even where the physical constraints of the current sensing coil impose challenging limitations on the impedance of the current sensing coil.

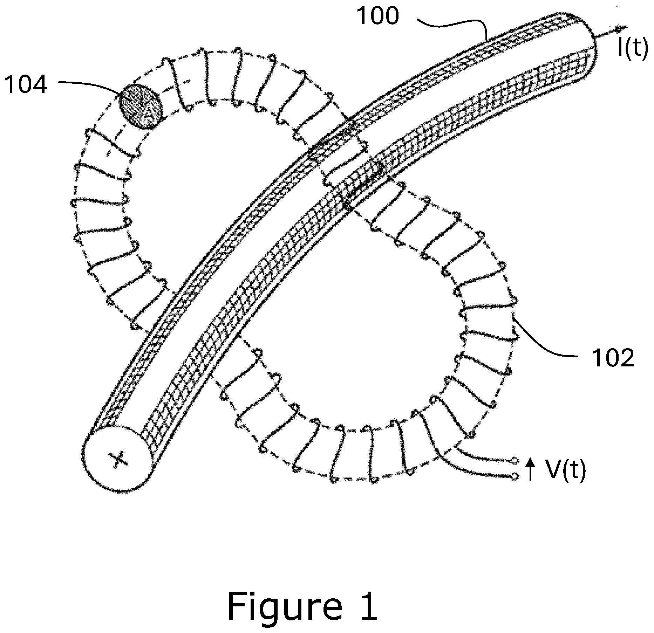

Figure 1 is a diagram of a current sensor coil (such as di/dt sensor or a Rogowski coil). So as to measure the current I(t) flowing through a current carrying conductor 100, a measurement coil 102 is arranged such that the current carrying conductor 100 passes through the measurement coil. The measurement coil 102 is wound as a helix, such that a loop or turn of the helix encloses a cross-sectional area 104. The current carrying conductor 100 may be, for example, a bus-bar.

As the current I(t) in the current carrying conductor 100 changes, the field generated by the current also changes. The positioning of the measurement coil 102 causes a voltage to be induced in the measurement coil 102 which is proportional to the rate of change of current, dI/dt. Therefore, integrating the output V(t) of the measurement coil provides a value proportional to the magnitude of the current. Each turn or loop of the coil forms a measurement area 104 in a plane perpendicular to the progression of the current carrying conductor 100. The greater the output voltage V(t) for a certain current, the greater the sensitivity of the coil. Having greater sensitivity allows the current sensor coil to determine or detect smaller currents in the presence of noise.

The Rogowski coil of Figure 1 is a single-ended Rogowski coil, including one measurement coil 102 which progresses around the conductor 100. A current sensor may include more than one measurement coil and/or be arranged to provide a differential output. Further, the measurement coil or coils may be provided on a printed circuit board (PCB) or substrate.

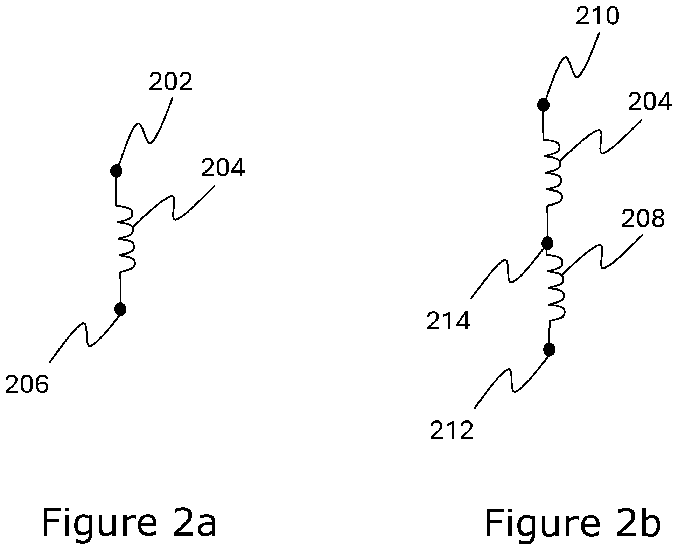

Figure 2a is a diagram of an equivalent circuit of a current measurement coil. The current sensor coil 204 has a first output node or terminal 202 and a second output node or terminal 206. Current sensor coils may be coupled in series to improve sensitivity or create a differential output signal. Figure 2b shows a differential system comprising a first current measurement coil 204 and a second measurement coil 208. The differential system comprises a first output node or terminal 210 and a second output node or terminal 212. The current measurement coils 204, 208 are coupled together at node or terminal 214. Node or terminal 214 may be coupled to a reference voltage or ground. As such, the output terminals 210, 212 provide a differential output signal. Other current measurement coils, comprising more than two measurement coils are not represented here, but should be understood to be compatible with this disclosure.

The output terminals of either current measurement coil may be coupled to further processing or logic circuitry, for example, an integrator to determine the output current from the measured differential signal, amplifier, buffers, analog to digital converters (ADCs), analog front ends (AFEs), processors, micro-processors. Further, the current sensor may form part of wider measurement systems, such as utility meters, current measurement systems, power measurement systems (when the current is measured in conjunction with a voltage), or fault detection and protection devices.

Figures 2a and 2b represent the measurement coils as inductors as the equivalent component of a measurement coil for clarity. As would be understood, the coils may have other parasitic values (resistance, capacitance) that are not shown in the figures.

The current sensor coil may be implemented on a PCB/substrate by creating coil loops using conductive traces on two or more layers of the board/substrate and conductive vias passing between layers of the board/substrate. For example, a first conductive trace may be drawn on a first layer of the board/substrate and be connected at one end to a first conductive via that passes through the board/substrate to a second layer. A second conductive trace may by drawn on the second layer and connected at one end to the first conductive via. The other end of the second conductive trace may be connected to a second via that passes back through the board/substrate to the first layer at a position that is offset from the first conductive trace. One end of a third conductive trace may be drawn on the first layer connected to the second conductive via. This arrangement may be repeated multiple times, with each set of traces and conductive vias offset from the previous set so as to form helical loops that progress around an opening in the board/substrate through which a current carrying conductor can pass. In this way, a current sensor coil can be implemented on a PCB/substrate in order to measure a current in the current carrying conductor.

The total gain of the current sensor coil (*Coil_gain*) is proportional to the area of each coil loop multiplied by the number of loops. As the PCB/substrate heats up, the board/substrate will expand, causing the area of each coil loop to increase. This, in turn, will increase the gain of the current sensor coil. Consequently, the gain of the current sensor coil is sensitive to temperature, which introduces a temperature dependent error in the current measurement. This may be expressed as $\frac{\Delta Coil\_Gain}{°C}$, or put another way, change in coil gain with temperature (eg, change per °C).

It may be possible to make a first order temperature correction using the resistance of the current sensor coil (referred to from hereon as "the coil" for simplicity) and the input resistance of the stage that follows the coil (for example, an amplification stage coupled to the coil in order to amplify the coil signal), since these also vary with temperature. As explained in more detail later, the resistance of the current sensor coil and the input resistance of the stage coupled to the coil together create a potential divider that has a gain *"Divider_Gain"*. For the reasons explained later, that gain is sensitive to changes in temperature, which may be expressed as $\frac{\Delta Divider\_Gain}{°C}$, or put another way, change in divider gain with temperature (eg, change per °C).

This may be used to tune an inverse temperature coefficient within the signal processing stage and cancel out the gain temperature coefficient of the coil. To put it another way, it may be possible to design the coil and/or the signal processing input stage to have impedances that result in the following relationship:

$$\frac{\Delta Coil\_Gain}{°C} = - \frac{\Delta Divider\_Gain}{°C}$$

This means that if temperature increases and the coil gain should go up, the divider gain should go down by the same amount, so the overall gain experienced by the signal that is generated by, and output from, the coil, and then processed by the signal processing circuitry, remains constant with temperature.

However, this relies on the coil resistance and the input resistance of the signal processing stage being particular values in order to correctly tune the temperature correction and achieve the balance identified above. There may be some practical limitations to achieving these required values in the design:

- The coil resistance may be controlled by changing the thickness of the coil traces during manufacture. However, once the traces are at or close to the minimum thickness of the PCB technology, the coil resistance cannot be made larger without increasing the size of the coil, which limits the smallest possible coil. It is often desirable to make coils as small as possible, in order to fit into tight spaces.
- For large coils, maintaining low resistance may require traces so thick that they significantly reduce the number of loops that can fit within a given PCB area, thereby limiting the maximum achievable gain.

Additionally, in applications demanding high stability from the current measurement system, each of the following limitations can contribute to unacceptable degradation in the accuracy of temperature-compensated measurements. As a result, post-manufacturing characterization of the PCB trace and/or amplifier resistance may be helpful in achieving more reliable performance.

- Inaccuracy in the coil resistance determination from the design values due, for example, to inaccurate information of copper weights and/or quality not being readily available for the PCB manufacturer.
- Coil-to-coil, board-to-board and/or batch-to-batch variations in coil resistance, due, for example, to inconsistencies in copper quality and/or thickness.
- Part-to-part and/or batch-to-batch variations in the amplifier resistance, due, for example, to integrated circuit (IC) manufacturing tolerances.

This disclosure seeks to improve the accuracy of current measurement by addressing at least some of these problems with temperature correction. In some implementations, the disclosure uses a stimuli (i.e., a reference or stimulating signal) to dynamically determine the ratio of the coil resistance (often referred to from here on as a "track" or "trace" resistance, since it is effectively the resistance of the conductive traces making up the coil) and the input resistance of the signal processing circuit coupled to the coil (most usually an amplifier). Such implementations may be useful where coil resistance and/or amplifier input resistance are difficult to accurately determine without measurement and/or where there is significant per-device, or per-batch, resistance variation. This determination can be used to set or adjust the temperature response of at least part of the signal processing circuitry, for example setting or adjusting a correction factor that modifies the signal processing (for example, the transfer function) of at least part of the signal processing circuitry in a way that reduces or corrects for changes in the signal caused by temperature changes. In other example implementations, the coil resistance and amplifier input resistance design values are sufficiently accurate and consistent not to require per-device, or even per-batch, measurement. In such implementations, the inventors have developed techniques described below where the temperature dependence of the overall system signal gain may be determined and used to set or adjust a correction factor that modifies the signal processing (for example, the transfer function) of at least part of the signal processing circuitry in a way that reduces or corrects for changes in the signal gain caused by temperature changes.

It should be noted that while explanations in this disclosure particularly focus on issues associated with a PCB implemented Rogowski coil, the techniques disclosed herein are equally applicable to other types of coil current sensors, such as a rope style coil or other di/dt sensor, that have an impedance. Furthermore, the disclosure also applies to implementations where the circuitry coupled to the coil has an impedance formed by any type of component. In particular, it is not limited to circuitry with an impedance formed by a resistor. The disclosure extends to circuitry having an impedance additionally or alternatively formed by other types of device(s), such as a switched capacitor.

Consequently, this disclosure may reduce or eliminate restrictions in place on the design of the coil that were previously present in order to achieve particular coil resistances, and better handle manufacturing tolerances in the coil and/or signal processing stage that cause variations in the actual impedance of the coil and/or input signal processing circuit compared with their design impedances.

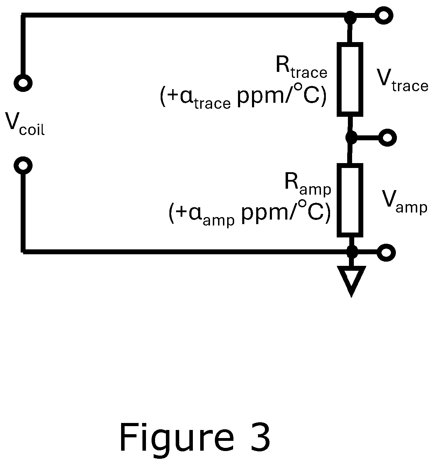

Figure 3 shows a schematic circuit representation of a coil and an input stage of signal processing circuitry (in this example, an amplifier coupled to the coil). The gain of the coil will typically increase with temperature (eg, by an amount $\frac{\Delta \text{Coil\_Gain}}{\text{°C}}$ ) because of expansion of the board/substrate, as explained above. $R_{trace}$ represents the parasitic resistance of the coil, not a separate component. $R_{amp}$ is a resistance in the signal path of the signal processing circuit, for example as part of a resistor defined gain stage coupled to the coil. The amount or ratio of the coil voltage $V(t)/V_{coil}$ that goes into the signal processing circuit (in this example, the amount that is amplified by the gain stage at the input of the signal processing circuit) depends on the divider ratio of $R_{trace}$ and $R_{amp}$.

$R_{trace}$ and $R_{amp}$ vary with temperature. The trace has a temperature coefficient $\alpha_{trace}$, and the amplifier input resistance has a temperature coefficient $\alpha_{amp}$. The trace is often made from copper and so $\alpha_{trace}$ may be a few thousand ppm/°C, while Ramp may be a few hundred or less ppm/°C and made, for example from polysilicon, P+/N+ doped diffusion or SiCr (Titanium Chrome) on Integrated Circuits or as discrete thin film or other discrete resistor types. Consequently, it may be assumed that $\alpha_{trace} > \alpha_{amp}$, in which case the divider ratio (and therefore the divider gain) may be assumed to decrease with temperaturel.

If the coil resistance and amplifier input resistance are correctly set so that the temperature dependent coil gain is cancelled by the temperature dependent divider gain, then:

$$\frac{\Delta V_{amp}}{\text{°C}} = \frac{\Delta Divider\_Gain}{\text{°C}} + \frac{\Delta Coil\_Gain}{\text{°C}} = 0$$

Where:

$$\frac{\Delta Divider\_Gain}{°C} = \frac{R_{trace}}{R_{amp}}\left(\alpha_{amp} - \alpha_{trace}\right)$$

A derivation of this can be found below.

The voltage Vamp may be defined by:

$$V_{amp} = V_{coil} - V_{trace}$$

$$V_{amp} = V_{coil} - \frac{R_{trace}}{R_{trace} + R_{amp}}V_{coil}$$

If we assume that $R_{amp} \gg R_{trace}$, then:

$$V_{amp} = V_{coil} - \frac{R_{trace}}{R_{amp}}V_{coil}$$

It is known that resistance R at a temperature T is defined by:

$$R = R_{ref}[1 + \alpha(T - T_{ref})]$$

Therefore, if the resistance of the trace at a reference/nominal temperature Tref is $R_{trace}$, the resistance of the trace at 1°C above Tref may be described as:

$$R = R_{trace}(1 + \alpha_{trace})$$

Likewise, if the resistance of the amplifier input at the reference/nominal temperature Tref is $R_{amp}$, the resistance of the amplifier at 1°C above Tref may be described as:

$$R = R_{amp}(1 + \alpha_{amp})$$

To determine divider gain:

$$Divider\_Gain = \frac{V_{amp}}{V_{coil}} = 1 - \frac{R_{trace}}{R_{amp}}$$

A change (delta) in divider gain per 1°C can be found by subtracting divider gain at the reference/nominal temperature Tref from the divider gain at 1°C above reference/nominal temperature Tref:

$$\frac{\Delta Divider\_Gain}{°C} = \left(1 - \frac{R_{trace}(1 + \alpha_{trace})}{R_{amp}(1 + \alpha_{amp})}\right) - \left(1 - \frac{R_{trace}}{R_{amp}}\right) = \frac{R_{trace}}{R_{amp}} - \frac{R_{trace}(1 + \alpha_{trace})}{R_{amp}(1 + \alpha_{amp})}$$

$$\frac{R_{trace}(1 + \alpha_{amp})}{R_{amp}(1 + \alpha_{amp})} - \frac{R_{trace}(1 + \alpha_{trace})}{R_{amp}(1 + \alpha_{amp})} = \frac{R_{trace} \cdot \alpha_{amp} - R_{trace} \cdot \alpha_{trace}}{R_{amp}(1 + \alpha_{amp})} = \frac{R_{trace}(\alpha_{amp} - \alpha_{trace})}{R_{amp}(1 + \alpha_{amp})}$$

It should be understood that $\frac{R_{trace}(1+\alpha_{trace})}{R_{amp}(1+\alpha_{amp})}$ is the pass ratio at 1°C above the reference/nominal temperature Tref, and $\frac{R_{trace}}{R_{amp}}$ is the pass ratio at the reference/nominal temperature Tref.

If we assume that $1 + \alpha_{amp} \approx 1$, then:

$$\frac{\Delta Divider\_Gain}{°C} = \frac{R_{trace}}{R_{amp}}\left(\alpha_{amp} - \alpha_{trace}\right)$$

Therefore, if it is desired to have $\dfrac{\Delta Coil\_Gain}{°C} = -\dfrac{\Delta Divider\_Gain}{°C}$ (as explained earlier), then it is desired to have the following relationship:

$$\frac{-\Delta Coil\_Gain}{°C} = \frac{R_{trace}}{R_{amp}}\left(\alpha_{amp} - \alpha_{trace}\right)$$

Since it is not always possible to design the coil and/or amplifier to satisfy this relationship, it may be possible to use a correction factor (CF) in order to satisfy the desired relationship:

$$\frac{-\Delta Coil\_Gain}{°C} = CF.\frac{\Delta Divider\_Gain}{°C}$$

$$\frac{-\Delta Coil\_Gain}{°C} = CF.\frac{R_{trace}}{R_{amp}}\left(\alpha_{amp} - \alpha_{trace}\right)$$

However, the inventors have recognised that since $R_{trace}/R_{amp}$ may vary board-to-board/batch-to-batch for the coil and/or the amplifier, a board-to-board/batch-to-batch determination of $R_{trace}/R_{amp}$ may enable CF to be set more accurately in order to satisfy the relationship above. Consequently, the effects of the change in coil gain with temperature ,may be more effectively reduced or cancelled by CF and the change in divider gain with temperature.

In particular, CF may be set based on:

$$CF = -\frac{\frac{-\Delta Coil\_Gain}{°C}}{\frac{R_{trace}}{R_{amp}}\left(\alpha_{amp} - \alpha_{trace}\right)}$$

**The** design values of $\alpha_{amp}$, $\alpha_{trace}$ and $\dfrac{-\Delta Coil\_Gain}{°C}$ may all be sufficiently accurate to be used in the setting of CF (they are unlikely to vary significantly part-to-part, and potentially even batch-to-batch, although in some implementations each manufactured batch of coils and/or amplifiers may have these values tested and the test values used for setting CF).

Furthermore, in some implementations the design values of Rtrace and Ramp may be sufficiently accurate to be used for the determination of CF without requiring them to be measured. However, in other implementations it may be beneficial to measure a value for the ratio of Rtrace and Ramp, on a device-by-device basis (i.e., a per-device basis), or on a batch basis (eg, measuring Rtrace/Ramp for one device in a batch and applying that to all devices in the batch), or on a design basis (eg, measuring Rtrace/Ramp for a particular design of the system and applying that to all devices of that design) in order to achieve a greater level of accuracy.

One technique devised by the inventors to determine the ratio of Rtrace and Ramp is to apply a stimulation or reference signal to the circuit and measure its effect on the circuit. **The** stimulation or reference signal may be any suitable type of signal having a predetermined magnitude, such as an oscillating or time varying signal, such as a sinewave or square wave, or any other suitable type of signal.

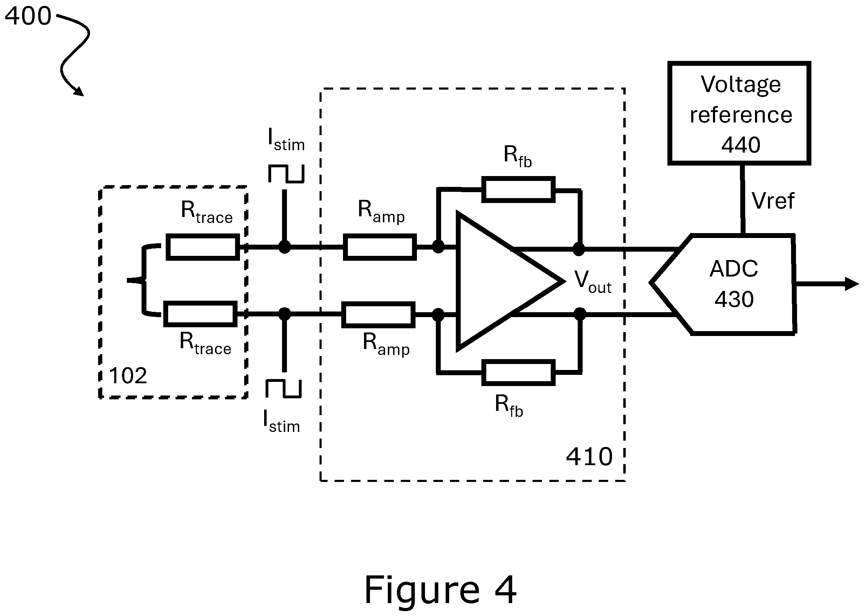

Figure 4 shows an example current measurement system 400 in accordance with an aspect of the present disclosure. In this example, the input to the signal processing circuit comprises an amplifier 400, an analog to digital converter (ADC) 430 and a voltage reference 440 for the ADC. The amplifier 400 is coupled to the coil 102 in order to amplify the coil signal. In this example, the output Vout of the amplifier 400 is digitally converted by the ADC 430, and may subsequently be digitally processed in any suitable way, for example in order to determine a measure of the current I(t) in the conductor 100. As is normal for ADCs, an ADC reference voltage Vref is set by the voltage reference 440. As briefly explained later, Vref may be set by a trim value that is stored as a digital value in memory that is part of the voltage reference 440, or is coupled to the voltage reference 440.

The ADC 430 and voltage reference 440 are not essential and may either come later in the signal processing circuit (for example, after one or more filters, etc), or may be omitted entirely with all signal processing being performed in analog. Optionally, a stimulation or reference signal Istim is injected or applied to the divider formed by Rtrace and Ramp for

the purpose of measuring the ratio of $R_{trace}$ and $R_{amp}$. In this example, $I_{stim}$ is a square wave signal having a known frequency and known magnitude/amplitude, but in an alternative it could be any type of oscillating signal, such as a sine wave, triangular wave, etc.

In the example where the stimulation or reference signal $I_{stim}$ is applied, Vout will include a signal component Vstim' that results from Istim, at about the same frequency of Istim. If Istim is to be applied during operation of the circuit in the field (i.e., while the coil is in place around a conductor 100 carrying a current I(t)), then the frequency of Istim may be chosen to be different to the expected frequency of I(t) (eg, different to the expected fundamental frequency of I(t) and any significant harmonics). For example, if the circuit is for measuring a mains current I(t) having a fundamental frequency of about 50Hz or 60Hz, then Istim may be set to have a fundamental frequency that is different to 50Hz or 60Hz (and optionally any significant harmonics), for example 2kHz, or 5kHz, etc, etc. In this way, Vstim' may be extracted from Vout, for example digitally in signal processing downstream of the ADC.

Istim may be generated to have a known magnitude/amplitude in any suitable way, which is explained in more detail later. In one example, it may be generated using a reference voltage Vref, such as one from a band-gap voltage reference or any other suitable type of voltage reference, and a resistance having a relationship to the amplifier resistance $R_{amp}$, $N.R_{amp}$. It may be described as follows:

$$I_{stim} = \frac{V_{ref}}{N \cdot R_{amp}}$$

Consequently, Vstim' may be defined as follows:

$$V_{stim}' = I_{stim} \frac{R_{trace}\, R_{amp}}{R_{trace} + R_{amp}} \frac{R_{fb}}{R_{amp}}$$

If we assume that $R_{amp} \gg R_{trace}$, which is usually the case, then:

$$\frac{R_{trace}\, R_{amp}}{R_{trace} + R_{amp}} \approx R_{trace}$$

Consequently:

$$V_{stim}' = \frac{V_{ref}}{N \cdot R_{amp}} \frac{R_{trace}}{R_{amp}} R_{fb}$$

$$\frac{R_{trace}}{R_{amp}} = \frac{V_{stim}' \cdot N \cdot R_{amp}}{V_{ref} \cdot R_{fb}}$$

In this example, it is assumed that a sufficiently accurate value for Ramp is known, which is often the case as per-device or per-batch variations in Ramp tend to be relatively small or negligible.

Thus, it can be seen that by applying a known reference signal Istim (which in this example is derived from a known reference voltage Vref) and measuring the resultant Vstim', then the ratio $\frac{R_{trace}}{R_{amp}}$ can be determined. As explained earlier, this enables a suitable correction factor CF to be accurately determined based on an actual measurement of $\frac{R_{trace}}{R_{amp}}$ of the circuit.

Regardless of how the correction factor CF is determined (for example by measuring $\frac{R_{trace}}{R_{amp}}$ as described above, or by using design values for $\frac{R_{trace}}{R_{amp}}$), it may be applied in order to set/alter/modify a temperature response of at least part of the signal processing circuitry in many different ways, for example any one or more of:

1. varying the temp coefficient of a reference voltage Vref used by the ADC 430

2. applying a digital gain correction factor in the signal processing circuit downstream of the ADC 430, using a digital multiplier;

3. trimming the value of Ramp

4. altering another parameter in a product, ie if the measurement of current I(t) is used to measure consumed power = I * V, it may be possible to alter the measurement of V to have the opposite temp coefficient so that it has the opposite temp coefficient to the measurement I, so that measured power is unaffected by changes in temperature

1. Varying Vref used by the ADC

For the first example, the reference voltage Vref used by the ADC 430 is used to set the temperature response of the signal processing circuit based on CF. In some examples, ADC reference voltages may have both an absolute and a temperature coefficient trim. In those examples, the temperature coefficient trim may set/adjusted based on CF. In other examples where there is a single ADC reference voltage trim, that is the trim that may be set/adjusted based on CF.

As briefly explained earlier, the reference voltage Vref may be defined, for example, by a digital value that is stored in memory in the system 400 (or in memory coupled to the system 400). An nitial Vref trim (for example, both the absolute and temperature coefficient trims of Vref) may be set for all systems of a particular design or set during testing of the ADC 430. However, the Vref trim (for example, the temperature coefficient trim value of Vref) may be set/adjusted based at least partly on the determined CF. In this way, Vref is altered, which in turn alters the temperature dependency of the ADC gain. Whilst this may degrade the temperature stability of Vref, which is a counterintuitive action to take, it does so in a way that reduces or eliminates the system's overall gain temperature dependency. As a result, by changing the Vref trim based on the CF, the temperature dependency of the ADC gain can be changed in a way that reduces or eliminates the overall gain temperature dependency of the system 400 as a whole.

This may be done on a per-device basis (i.e., each Vref trim adjustment is particular to each device, for example based on per-device determinations of CF), or on a per- batch basis (for example, the change in Vref trim being determined by a calibration process on one device and then applied to all devices in the same manufacturing batch).

Optionally, the system may be configured such that the range of possible adjustments that can be applied to the Vref trim is asymmetric about the initial trim value. For example, if the trim value is an 8-bit value, the system may be configured such that the initial trim value is not at the mid-point of the 8-bit value, but is instead closer to one end of the range than the other. This may be particularly beneficial when the signal processing system supports a wide coil resistance range (i.e., where the signal processing circuitry may be used in combination with a wide range of different coil 102 types, with a correspondingly wide range of Rtrace values), and the value of Ramp is such that the required value of Rcoil for a flat system temperature response (without making any signal processing system adjustment based on CF) is not centred within the supported coil resistance range. For example, if the supported coil resistance range is 0 to 25 ohms, but the optimal Rcoil value without any CF based adjustment to the signal processing circuit is 3 ohms, then only a relatively small amount of CF based trim of Vref would be required for coils having a resistance close to 0 ohms, but a relatively large amount of CF based trim of Vref would be required for coils having a resistance close to 25 ohms.. Consequently, the inventors have determined that if the default Vref trim value (which corresponds in this example to a 3ohm coil) is set asymmetrically within the range of possible Vref trim values, a larger range of trim values may be available for coils having a resistance in this example between 3-25 ohms compared with the range of trim values available for coils having a resistance in this example between 0-3 ohms. This means that the available resolution of trim adjustment (i.e., the change in ADC reference voltage caused by each bit change in the trim value) may be kept relatively fine for a wide range of coil types, whilst still keeping the length of the trim code relatively low (for example, 8-bits), thereby minimising complexity and memory requirements.

Whilst one particular example technique for setting Vref, specifically setting a suitable trim code based on CF, is given above, the skilled person will appreciate that Vref may be generated and set in various different ways, all of which can be used for the system of 400.

The setting to apply for Vref (for example, the required modification to the initial trim code) may be determined from CF in a variety of different ways. For example, there may be a look-up table (stored in memory in the system 400, or stored elsewhere and accessible to an operator of the system 400 who is performing configuration) that stored a plurality of different CF values and corresponding Vref control settings. In a further example, a formula may be used to determine the required Vref control setting as a function of CF.

2. Digital multiplier

The system 400 may further comprise a digital, or binary, multiplier anywhere in the signal processing chain downstream of the ADC 440. The determined CF, together with a dynamic measurement of the operating temperature (obtained using any suitable method familiar to a knowledgeable engineer), can be used to calculate an appropriate multiplication factor for the digital multiplier (for example, using a look-up table, or formula, etc, as explained above). This factor sets the scale by which the digital signal representing the current measurement should be adjusted for that specific operating condition. In this way, the gain temperature coefficient of the signal processing circuit may be altered in such a way as to reduce, or eliminate, the overall temperature gain coefficient of the system 400 as a whole.

### 3. Trimming the value of Ramp

The resistors Ramp may may implemented as trimmable, or variable, resistors. The determined CF may be used to determine an appropriate trim to the resistance of Ramp (for example, using a look-up table, or formula, etc, as explained above). As explained earlier, this should alter the temperature dependency of the divider gain (i.e., $\frac{\Delta Divider\_Gain}{^\circ C}$), such that it more closely cancels out the temperature dependency of the coil gain (i.e., $\frac{\Delta Coil\_Gain}{^\circ C}$). This should reduce, or eliminate, the overall temperature gain coefficient of the system 400 as a whole.

### 4. Altering another parameter in a product

The system 400 may be part of a wider product system, for example a utility meter configured to measure energy consumption based on a measure of current and voltage. In this example, the wider product system would also include a voltage measurement system/channel that could be modified in some way based in order to reduce or eliminate any temperature dependent gain in the overall energy measurement, caused by a temperature dependent gain in system 400. Any suitable technique may be used to modify that other part of the wider product system, for example trimming one or more amplifier resistors, applying digital gain, altering the reference voltage used by an ADC, etc.

It should be noted that the setting/modification applied based on the determined CF may be designed to create a zero, or near zero (for example, close enough to zero for the accuracy of the system over the operating temperature range to be within acceptable design limits), temperature coefficient for the gain of the full system 400 including coil 102 impedance, amplifier 410 impedance, and any other system circuits/units, such as reference system and/or ADC 430. In an alternative, the setting/modification applied may be designed so that the overall temperature coefficient is not zero, and is instead some non-zero target value (or to be within an acceptable proximity to the non-zero target value, such as within +/- 1%, or +/- 2%, +/- 5%).

In all of the above, the temperature response of the signal processing circuitry is set/modified based on the determined CF. In an alternative, the appropriate setting/modification may be determined just from the impedance ($R_{trace}$) of the coil 102. For example, the impedance $R_{amp}$ may be known with sufficient accuracy from the design value for $R_{amp}$. The signal processing circuitry may be intended for use with a variety of different coil types, each of which may have a different impedance $R_{trace}$. Since $R_{amp}$ is known (to an acceptable degree of accuracy) and fixed for the system 400, the only variable is the type of coil 102 that is being used. As a result, an operator may simply use the impedance $R_{trace}$ of the type of coil 102 they have chosen to use in order to determine the setting/modification to be applied to the temperature response of the signal processing circuitry (for example, using a look-up table or formula that maps values for $R_{trace}$ to signal processing circuit settings).

It will be appreciated that by virtue of the techniques described above, the signal processing circuitry may be used for a variety of different coil 102 types, thereby enhancing flexibility and simplicity, and reducing costs (since only a single type/design of signal processing circuitry is needed, rather than different designs for different coils), whilst still maintaining a high level of current measurement accuracy. For example, the signal processing circuitry may be implemented in an IC/chip and may be used for a wide range of different types of coils 102. In some examples, the temperature response of the signal processing circuitry may be set based on the design value of the coil impedance $R_{trace}$ and/or the design value of the signal processing input impedance $R_{amp}$. In other examples, it may be set based on a measurement of $R_{trace}$ and/or $R_{amp}$ and/or a ratio of $R_{trace}$ and $R_{amp}$.

Returning to examples where the ratio of $R_{trace}$ and $R_{amp}$ is measured, the reference/stimulation signal $I_{stim}$ shown in Figure 4 may be generated in any suitable way. In one example, it may be generated from a voltage reference having a predetermined magnitude with a resistor that has a known resistance that is related to Ramp - for example having a resistance $N*R_{amp}$, where N is set to any suitable value based on the known values of the voltage reference and $R_{amp}$ and the desired magnitude of Istim. For example, N resistor components each having a resistance $R_{amp}$ may be combined to have a resistance N*Ramp, which is coupled to a voltage source to create the voltage $I_{stim}$ = Vreference / $N*R_{amp}$. The resistance $N*R_{amp}$ may be switchably coupled to the output of the coil/input of the amplifier 400 so as to switchably apply $I_{stim}$ to the measurement signal chain. The switch may be used to straightforwardly apply or disapply Istim (for example, to turn on and turn off the use of Istim), or may be used to oscillate Istim during application of Istim, by turning on and off at a predetermined frequency so that Istim is applied for a period of time as an AC signal. The signal from the voltage source may be at a different frequency to that of the signal level from the coil 102, so it can be isolated from the signal Vout with various stimuli and analysis conditions.

The generated reference current Istim may be copied, scaled and switched to be any of: a unipolar signal, a single-ended signal, a bipolar signal, a pseudo-differential signal or a differential signal. Istim can be steered between positive and negative and can be pulled up or down relative to the common mode of the amplifier 400 input.

Istim may be a DC signal or an AC signal. If it is AC, it can be a two-level signal (for example by switching the signal "on" and "off" at a predetermined frequency), or can have more than two levels, for example resembling a Piece Wise Linear (PWL), pseudo random sequence or virtual sine wave. The frequency and/or phase of Istim may be fixed, or may be changed at any desired time, for example to help distinguish it from other signals or noise in the system.

The application of Istim can be turned on or off at any suitable time, for example so that it is only applied during system start up, or intermittently or periodically during system operation, or on demand.

Vstim' may be recovered from the signal Vout in any suitable way. For example, by locking a digital version of Vout to a digital version of Istim. An average, mean, median and/or histogrammed version of multiple measurements of Vout may be used to help discern the difference between the Vstim' signal that is to be extracted, and other signals and noises in Vout.

Returning again to the formula:

$$\frac{R_{trace}}{R_{amp}} = \frac{V_{stim}' \cdot N \cdot R_{amp}}{V_{ref} \cdot R_{fb}}$$

It can be appreciated that $N*R_{amp}$ is known since it is the known resistance of the resistor used to set $I_{stim}$. $R_{fb}$ is also known as the resistance of the amplifier feedback resistors and $V_{stim}'$ is extracted from $V_{out}$. It should be understood that to make resistors that track each other, the same material or type of resistor may be preferable, as is making them out of multiple parallel/series combinations of a unit resistor, $R_{unit}$. In all cases, there may be a largely known, predictable relationship between $R_{amp}$, $R_{stim}$ and $R_{fb}$, even if they are not exact multiples of each other. Mixtures of resistor types can be used for each resistor (ie a combination of positive and negative temperature resistors to make a compound resistor with a different net Temp coeff).

Whilst in the examples above, $I_{stim}$ is applied to the signal path between the coil 102 and amplifier 410 in order to measure $\frac{R_{trace}}{R_{amp}}$, various alternatives are possible.

For example, the PCB/substrate on which the coil 102 is formed may also include a separate, test conductive trace/track. Its resistance $R_{test}$ may optionally be higher than that of the coil trace and/or the test trace/track be longer than the trace forming the coil. It could be at a different location on the PCB/substrate to that of the coil (eg, having separate connection PINs to those of the coil, to which a reference/stimulation signal can be applied). The reference/stimulation signal $I_{stim}$ may be scaled to $R_{amp}$ by generating it in dependence on $N* R_{amp}$, as described above. The stimulation signal $I_{stim}$ can then be applied to the test trace/track and the voltage $V_{test}$ across the test trace/track measured in order to determine the resistance $R_{test}$ of the test trace/track. Consequently:

$$R_{test} = \frac{V_{test}}{I_{stim}}$$

Since:

$$I_{stim} = \frac{V_{ref}}{N \cdot R_{amp}}$$

Then:

$$R_{test} = \frac{V_{test} \cdot N \cdot R_{amp}}{V_{ref}}$$

$$\frac{R_{test}}{R_{amp}} = \frac{V_{test} \cdot N}{V_{ref}}$$

In some instances, owing to the size and design of the test trace/track, it may be reasonable to assume that Rtest = Rtrace, in which case the ratio $\frac{R_{trace}}{R_{amp}}$ has been found. In other instances, there may be a known approximate relationship, in which case the determined value for $\frac{R_{test}}{R_{amp}}$ may be scaled according to the approximate relationship in order to determine $\frac{R_{trace}}{R_{amp}}$ .

In some other examples, $R_{amp}$ and $R_{trace}$ may be separately determined and the values brought together to determine the ratio. In some instances, approximations of $R_{amp}$ and/or $R_{trace}$ may be used, and/or proxies may be measured. For example, it may be possible to determine $R_{amp}$ and $R_{trace}$ separately, and then bring the two values together to determine the ratio. In some cases where the coil and signal processing circuit are manufactured separately and then later brought together to form the current measurement system/circuit 400, their impedances may be separately measured and then combined to determine $\frac{R_{trace}}{R_{amp}}$ at the time that coil and signal processing circuit are combined to form the current measurement system/circuit 400 the temperature dependency of the signal processing circuit is configured/tuned as explained earlier . For example, the separately determined values may be recorded in any suitable way, for example device-by-device values, or batch values, stored in a database, or indicated on the devices themselves (such as in a barcode/QR code on the device, or printed onto the device).

$R_{amp}$ may be determined or set in a variety of different ways. For example, a value for $R_{amp}$ may be determined at the time of manufacture and/or calibration, for example it may be measured, or simply assumed to be the design resistance (for example if the spread on Ramp was deemed to be sufficiently small, particularly if the resistor was trimmed, or selected). In this case, Ramp may be stored in any suitable way (such as using memory, such as non-volatile memory or through some other traceable method, such as a database linked to the amplifier part or batch). The stored value may then be combined with a measurement of Rtrace to arrive at a sufficiently accurate ratio $\frac{R_{trace}}{R_{amp}}$ . In a further alternative, a proxy/replica amplifier (i.e., a separate duplicate of the amplifier 400) may be included in the IC in which amplifier 410 is formed. Reference voltage and/or current signals may be applied to the proxy amplifier in order to determine its input resistance, which may be assumed to be the same as, or have a known relationship to, $R_{amp}$. In this way, $R_{amp}$ may be measured using a proxy, without interfering with the actual measurement signal chain of the circuit.

A measurement of $R_{trace}$ may be obtained in many different ways. In one example, the PCB/substrate on which the coil is formed may also include a separate, test conductive trace/track as explained above. However, rather than apply a current stimulation $I_{stim}$ that is scaled with $R_{amp}$, a current stimulation signal unrelated to $R_{amp}$ may be used to measure $R_{test}$. In some instances, $R_{test}$ can be assumed to be the same as $R_{trace}$, and in other instances where the test trace/track is a scaled version of the coil trace, a scaling factor may be applied to $R_{test}$ to arrive at $R_{trace}$.

In a further alternative, a potential divider made of a matched (scaled or not) version of $R_{trace}$ and $R_{amp}$ may be used. A reference voltage may be applied to that potential divider and the voltage drop of the potential divider measured, from which the potential divider ratio may be determined (and by extension the ratio of $\frac{R_{trace}}{R_{amp}}$ ).

Regardless of how the $R_{trace}$ and $R_{amp}$ are determined, further points to note are:

- The correction factor CF may be positive or negative
- The signal processing circuit setting/adjustment that is applied based on CF (or just on $R_{trace}$, as explained earlier) may be set to target a non-zero net effect (i.e., so that it could be taking out another quasi-static temperature effect (such as the expansion of the PCB) that is on top of the impedance related effect. For example, in effect CF may be such that

$$\frac{\Delta Coil\_Gain}{°C} + CF.\frac{\Delta Divider\_Gain}{°C} \neq 0$$

but instead equals a value that may correct for another effect. For example, in an energy measurement system, if there was a temperature coefficient on the voltage measurement that is used for the energy measurement, or a temperature coefficient on a clock in the system, and it was desirable that the energy measurement is temperature stabilised, the target temperature coefficient of the system for the current measurement may be made to compensate one or both of the voltage and clock temperature coefficients. As Energy = Current * Voltage * Time, in this way the compound performance of Energy measurement may be improved at the expense of the performance of any one of Current, Voltage or Time.

- The coil does not need to be differential, it could be single ended, for example as shown in Figure 2a.
- These techniques could be applied even when the impedance ratio includes at least one component that is not a pure resistance (for example, where the first signal processing stage coupled to the coil is a switched capacitor ADC).
- Determination of $\frac{R_{trace}}{R_{amp}}$ and the CF could be performed intermittently or periodically during operation of the measurement circuit, and/or at power up of the circuit. The signal processing circuit temperature response that is set may not always (or ever) be updated based on the determined $\frac{R_{trace}}{R_{amp}}$. Instead $\frac{R_{trace}}{R_{amp}}$, and/or CF, may be determined simply to check that they remain within a reasonable margin of a stored value for $\frac{R_{trace}}{R_{amp}}$ and/or CF, to ensure that the circuit is operating with acceptable accuracy and has no faults.
- A temperature measurement can be used to take out the 'nominal' setting and to compensate any second order effect in the temp coefficient differences.

In all of the above, $R_{trace}$ and/or $R_{amp}$ is determined, and optionally then CF, in order to determine the appropriate one or more signal processing circuit settings. In an alternative, the temperature dependency of the overall gain of the system 400 (i.e., the temperature dependent signal gain of the system) may be determined through measurement and then used to determine the appropriate one or more signal processing circuit settings in order to reduce the temperature dependency of the overall gain of the system 400.

For example, a known current may be applied to the conductor 100 and the current may be measured by the system 400. This may be repeated with the system 400 being held at a plurality of different temperatures within a range of temperature, for example within a range of temperatures between 15-65 degC. Since the current in the conductor 100 is known and held constant, the way in which the measured current changes with temperature will show the temperature dependent signal gain of the system 400 as a whole. That determination may then be used to make an appropriate setting/adjustment to the temperature response of the signal processing circuitry, for example using any one or more of the techniques described above. This process may be performed on a per-device basis, or on a per-batch basis (for example, performed on one device with the determining settings applied to all devices from that batch), or a per-design basis (for example, perform on one device having a particular design, and then applied to all devices that have that design).

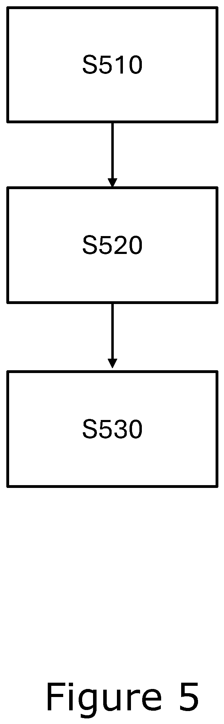

Figure 5 shows an example method of setting the temperature response of the current measurement system 400. In step S510, the impedance of the current sensing coil 102 and/or the impedance of the signal processing circuitry is determined (for example, based on design values, or through measurement) and/or the temperature dependent signal gain of the current measurement system is determined. In Step S520, the required signal processing setting/adjust is determined to set the temperature response of the signal processing circuit to cause the temperature dependency of system gain to be reduced or eliminated based on the impedance of the current sensing coil 102 and/or the impedance of the signal processing circuitry and/or the determined temperature dependent signal gain of the current measurement system. In Step S530, the temperature response of the signal processing circuitry is set.

Tamper and/or failure detection

The inventors have realised that some similar techniques may be used to detect a measurement circuit tamper or failure.

As explained earlier, a PCB/substrate formed coil is made from a series of traces and vias. Over the lifetime of the coil, it is possible for traces and/or vias to develop a short or an open that affects part or all of the coil's sensitivity, by effectively removing or attenuating part or all of the turns of the coil. For example, a short may prevent the turns behind the short from passing on their signal. An open may mean that the measurement signal does not reach the output terminals of the coil for measurement.

Consequently, a fault may manifest itself as a smaller, or even non-existent, measurement of current, which may not be discernible. For example, it is difficult to tell if no current is measured because of an open circuit fault, or because there is genuinely no current present to be measured.

In some instances, these faults may occur naturally, for example as a result of environmental wear. In other instances, it may be a result of deliberate tampering, for example because the current measurement circuit is part of a utility meter and there is a desire to avoid paying for all of the energy being consumed. Deliberate tampering can take many different forms, which include any one or more of:

- drilling and/or laser cutting the traces on the PCB, to create an open
- soldering and/or applying conductive paint across parts of the coil, to create a short

In some instances, it may be possible for damage or tampering to result in current still being measured, but at a lower magnitude than the amount of current actually being consumed. In particular, adding a conductive component across the coil may attenuate the measurement signal. For example, if the coil has a resistance of 5Ω, connecting a 1Ω resistor across it should reduce the output measurement signal to 1/5 of the amplitude that it should be.

Similar techniques to those described earlier may be used to detect a change in $R_{trace}$ that may be caused by tampering, or natural degradation, or failure. For example, the technique described in Figure 4 can be used to determine $\frac{R_{trace}}{R_{amp}}$. This could be directly used to compare against a reference value for $\frac{R_{trace}}{R_{amp}}$ (which may either have been measured at time of circuit manufacture/calibration, or may have been set for all manufactured circuits within a batch or all manufactured circuits having the same design). If the determined $\frac{R_{trace}}{R_{amp}}$ is different to the reference value by more than a predetermined threshold, it may be concluded that a failure or tamper has occurred. In an alternative, a value for $R_{trace}$ may be determined from the measured $\frac{R_{trace}}{R_{amp}}$, based on a determined or known value for $R_{amp}$ (which may be known or determined in various different ways, as explained above). The determined value for $R_{trace}$ may then be compared against a reference value for $R_{trace}$ (which may either have been measured at time of coil manufacture/calibration, or may have been set for all manufactured coils within a batch). If the determined $R_{trace}$ is different to the reference value by more than a predetermined threshold, it may be concluded that a failure or tamper has occurred. $\frac{R_{trace}}{R_{amp}}$ and/or $R_{trace}$ may be determined on command (for example, by an in person or remote command from a utility provider), or periodically or intermittently, or continuously. The outcome of the measurement (eg, the measured $\frac{R_{trace}}{R_{amp}}$ and/or $R_{trace}$ and/or the outcome of the "fault/tamper = yes or no" determination) may be reported regularly (for example, to a utility provider that has a data connection with the utility meter) or only when a fault/tamper is detected. When a fault is detected, various actions are possible, including:

- disconnection of the utility supply, for example remotely using a relay
- audio and/or visual indication on the utility meter
- communication to a remote device/entity, such as a utility provider

These actions may be initiated regardless of how the fault/tamper is detected (for example, using any one of the techniques disclosed herein).

Some faults may enable an estimation of actual current consumption still to be determined. For example, if the reference value for $R_{trace}$ is 5Ω and is stored, for example in memory, but a tamper or failure has been detected (for example, $R_{trace}$ is measured as 1Ω because of a tamper causing parallel attenuation), an estimated measurement of current may be determined using the stored, reference value for $R_{trace}$. This may be useful for estimating what a utility meter bill should have been in the event that a tamper is proven.

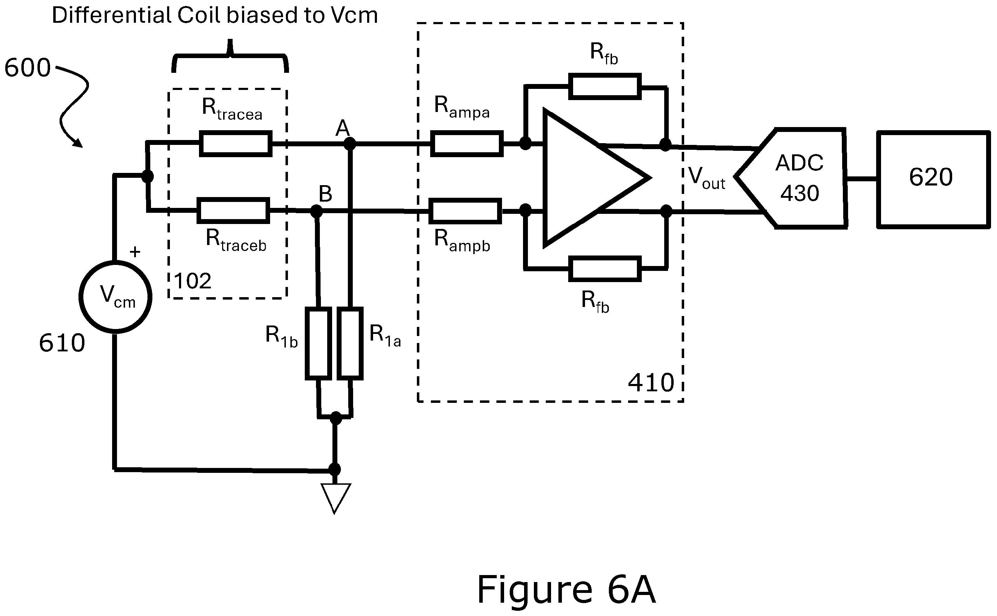

Figure 6A shows a further example system 600 that can be used for tamper or failure detection, in accordance with an aspect of this disclosure. In this example, the coil 102 is a differential coil that is biased to a common mode voltage Vcm. The system includes a common mode voltage source 610 (which may be implemented by any suitable voltage supply) and resistors R1a and R1b coupled between the common mode voltage source 610 and the output of the coil 102/input of the signal processing circuitry. The signal processing circuitry of the system 600 further comprises a determination unit 620 configured to determine whether or not there is a tamper/failure of the coil 102. The determination unit 620 may be implemented in any suitable way in order to perform the functionality described below, for example as a dedicated circuit, or as programable logic (such as an FPGA), or a microcontroller, or a processor (such as a microprocessor) configured to executed software instructions to perform the below described functionality. Furthermore, whilst it is shown as a digital device in Figure 6A, in an alternative it may be implemented as an analog device and may either be positioned in parallel to the ADC 430, or the ADC 430 may be omitted entirely from the signal processing circuitry.

If R1a and R1b are both set to be the same value, a load current defined by Vcm / (Rtracea + R1a) should be introduced/injected and sourced through the coil. The load current may be referred to as a DC test signal. However, in all of the examples of the present disclosure, Vcm does not have to be a DC signal and could have an AC component, such that the load current defined by Vcm has an AC component. In this case, Vcm may be controlled such that the AC component has a known frequency, which is different to the fundamental frequency of the current signal in the conductor 100 (and optionally also different to one or more harmonics of that signal) so that it can be extracted from the signal that is processed by the signal processing circuitry and measured.

If there is an open in Rtracea, then an offset should appear on Vout that is roughly equal to Vcm*(Rfb/(Rtracea+Rampa). Likewise, if there is an open in Rtraceb, then an offset should appear on Vout that is roughly equal to Vcm* (Rfb/(Rtraceb+Rampb). Therefore, detection of an offset in Vout should indicate that an "open" fault/tamper has occurred. As such, the determination unit 620 is configured to determine whether or not there is an offset in Vout, for example by determining a measure of DC offset in Vout and comparing it to a reference DC offset (in this example, 0). If they are different by more than a threshold amount, then it may be determined that there is a fault/tamper. The threshold amount may be set to any suitable value based on typical noise levels in the measurement of DC offset and/or the typical amount of signal offset that is introduced by the amplifier itself, depending on the design and typical operation of the system 600.

However, if there is a short between nodes A and B, it is unlikely that any offset or change will be seen in Vout. Likewise, if there is an open in both Rtracea and Rtraceb, it is again unlikely that any offset or change will be seen in Vout.

One solution to this is to make the values of R1a and R2a different. In this case, when Rtracea and Rtraceb are matched and everything is operating correctly, there should be an offset in Vout. This offset may be known (for example, measured at the time of manufacture, or simply known from the relative component values) and may be removed from the measurement of current during device operation, for example by a high pass filter in the signal processing circuitry. If there is a change in either or both of Rtracea and Rtraceb, including both an open or short, the offset should change. This change in the offset of Vout can be detected, such that any type of open or short fault/tamper should be detectable. The offset may be extracted by looking at a low pass filtered or integrated version of the output Vout, knowing the sensor itself is not very sensitive in that region of frequency operation. In this case, the determination unit 620 may be configured to determine a measurement of the DC offset in Vout and compare it against a reference DC offset that may be stored in memory, for example memory that is part of, or accessible to, the determination unit 620. If they are different by more than a threshold amount, then it may be determined that there is a fault/tamper. The threshold amount may be set to any suitable value based on typical noise levels in the measurement of DC offset, depending on the design and typical operation of the system 600. The reference DC offset may have been set at an earlier time, for example during manufacture or calibration, based on signal measurements or based on the design value of the components and circuits of the system 600.

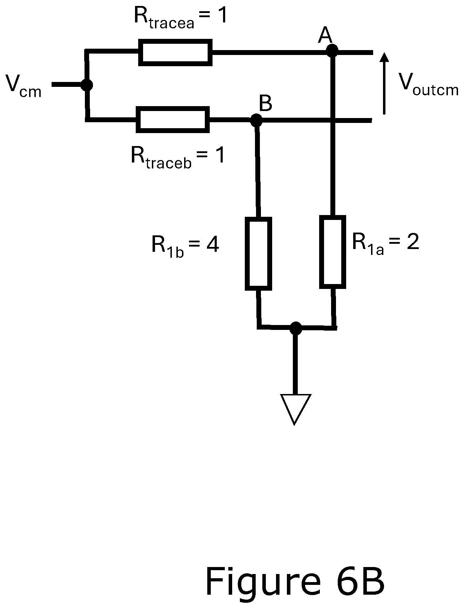

Figure 6B shows an example schematic to help understand this effect. In this example, Rtracea and Rtraceb are at a nominal resistance of 1ohm, although they may alternatively have any resistance. R1a and R1b have different resistances to each other, and in this example R1a = 2 ohms and R1b = 4ohms (although they may alternatively have any other mismatched resistance values).

The common mode voltage, Voutcm, that is received by the amplifier 410 is:

$$Voutcm = VA - VB$$

$$Voutcm = Vcm\left(\frac{R1a}{(R1a + Rtracea)}\right) - Vcm\left(\frac{R1b}{(R1b + Rtraceb)}\right)$$

Under normal operating conditions where Rtracea = Rtraceb = 1 ohm, and R1a = 2 ohms and R1b = 4 ohms:

$$Voutcm = Vcm\left(\frac{2}{3} - \frac{4}{5}\right) = -\frac{2Vcm}{15}$$

If there is a failure or tamper such that Rtracea is shorted, then VA = Vcm, in which case:

$$Voutcm = Vcm - Vcm\left(\frac{R1b}{(R1b + Rtraceb)}\right)$$

$$Voutcm = Vcm\left(1 - \frac{4}{5}\right) = \frac{Vcm}{5}$$

If there is a failure or tamper such that Rtraceb is shorted, then VB = Vcm, in which case:

$$Voutcm = Vcm\left(\frac{R1a}{(R1a + Rtracea)}\right) - Vcm$$

$$Voutcm = Vcm\left(\frac{2}{3} - 1\right) = -\frac{Vcm}{3}$$

If there is a failure or tamper such that Rtracea is open, then VA = 0, in which case:

$$Voutcm = 0 - Vcm\left(\frac{R1b}{(R1b + Rtraceb)}\right)$$

$$Voutcm = Vcm\left(0 - \frac{4}{5}\right) = -\frac{4Vcm}{5}$$

If there is a failure or tamper such that Rtraceb is open, then VB = 0, in which case:

$$Voutcm = Vcm\left(\frac{R1a}{(R1a + Rtracea)}\right) - 0$$

$$Voutcm = Vcm\left(\frac{2}{3} - 0\right) = \frac{2Vcm}{3}$$

As can be seen, Voutcm is different for all four of these different tamper/failure conditions, and different to Voutcm when the system is under normal operating conditions. As a result, a tamper/failure can be detected based on the common mode of the signal that is processed by the signal processing circuitry.

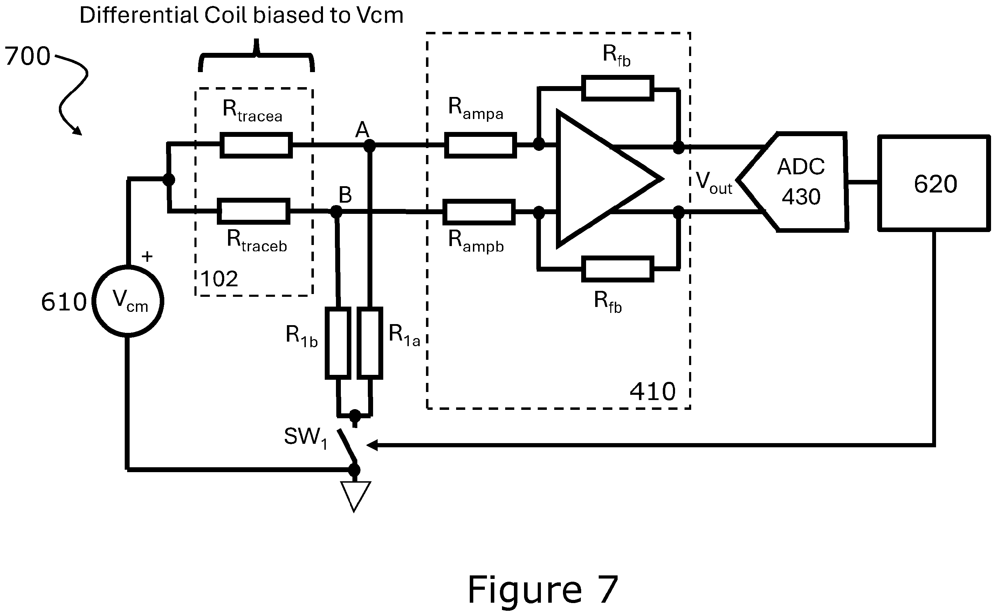

Figure 7 shows a further example system 700 in accordance with this disclosure. This technique is similar to Figure 6A, but includes a switch SW1. In this example, the determination unit 620 is configured to control the switch SW1, although in an alternative it may be controlled by any other suitable device/unit. This makes it possible to selectively apply the potential across R1a and R1b in order to selectively operate in a test mode (where the switch SW1 is closed and the DC test current is applied) and in a non-test mode (where the switch SW1 is open and the DC test current is not applied). To put it another way, it can switch the circuit between a common mode load (the test mode) when the switch is open, and a differential load when the switch is closed (the non-test mode).

It should be noted that in these tamper/fault detection aspects, a DC load (stimulation) is applied to the coil outputs and used for fault/tamper detection. This DC analysis may be effective in part because the coil is not sensitive to DC and so it should not affect the accuracy of AC current measurement performed by the circuit.

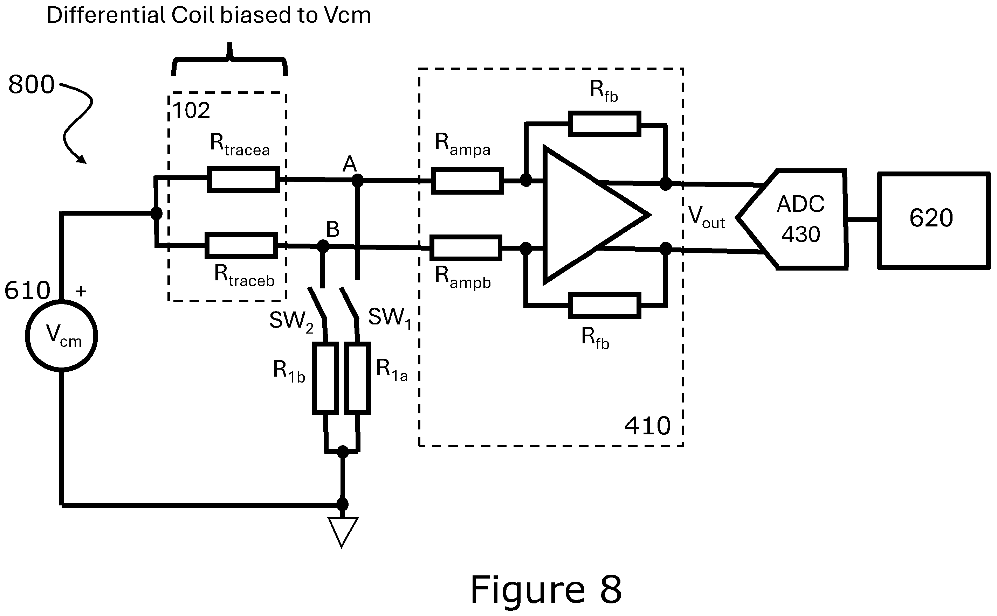

Figure 8 shows a further example system 800. In this example, the resistors R1a and R1b are again switchable, but using switches SW1 and SW2. The determination unit 620 may again be configured to control the switches SW1 and SW2, although that is not represented in Figure 8 for the sake of simplicity. The operation of system 800 is the same as that of system 700, except both switches SW1 and SW2 are controlled in order to switch between test and non-test modes.

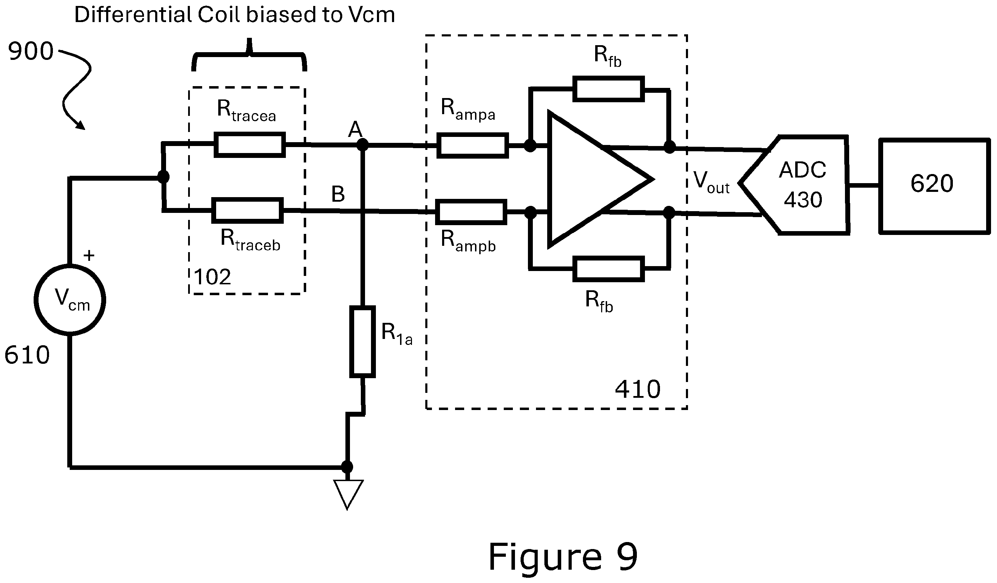

Figure 9 shows a further example system 900 where only one of R1a and R1b are present (in this example, R1a is present, but in an alternative only R1b may be present). It should be appreciated that this arrangement will also result in an offset in Vout similar to the example above where R1a and R1b are both present, but have different impedances. Optionally, a switch may also be used to make this resistor switchable, as shown in Figures 7 and 8.

Whilst Figures 6 to 9 show the use of resistors for injecting the DC current stimulation, in an alternative any suitable type of current source may be used.

The DC current stimulation signals may be generated either within the IC in which the signal processing circuitry (which includes the amplifier 400) is implemented, or outside of the IC (i.e., the loads R1a and R1b and/or Vcm, or the current source(s), may be inside or outside of the IC in which the signal processing circuitry is implemented).

Regardless of how a fault/tamper is detected, if one is detected, the determination unit 620 may be further configured to perform a predetermined fault/tamper action, such as outputting one or more signals that cause any one of the following:

- disconnection of a utility supply (for example, where the system is implemented within a utility meter, it may cause a circuit breaker in the utility meter to open, or for the power supply to be cut off elsewhere, for example further upstream in the grid/network)
- output an audio and/or visual indication of fault/tamper, such as a visual message or an audio alarm;
- output a fault/tamper message to a remote device/entity, such as a utility provider

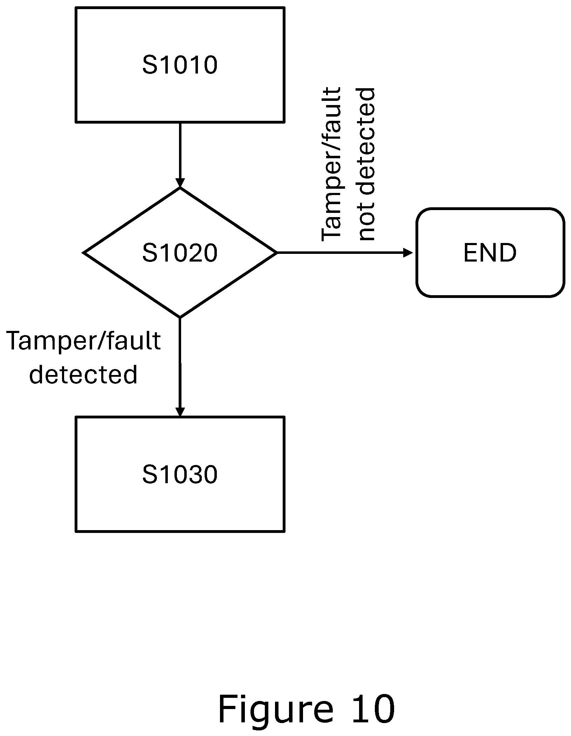

Figure 10 shows an example method by which a fault/tamper may be detected. In step S1010, the DC test signal is applied to at least one output terminal of the current sensing coil 102. In Step S1020, it is determined whether there is a fault/tamper based on the DC component in the signal that is processed by signal processing, for example by comparing it to a reference DC offset. If a fault/tamper is detected, in optional Step S1030 a predetermined fault/tamper action is performed, such as outputting an alert.

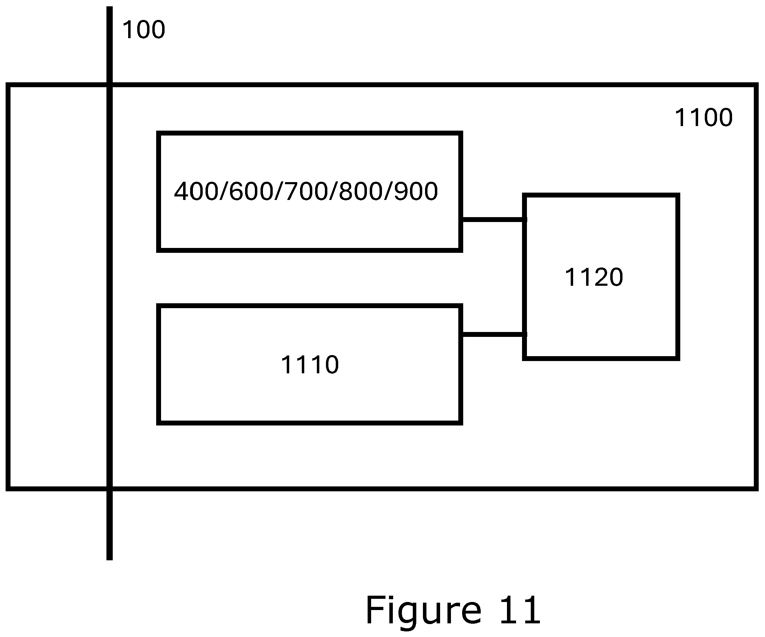

Figure 11 shows a representation of an example utility meter 1100, for example a domestic utility meter for installation in a home, or an industrial utility meter for installation in an industrial unit. The utility meter 1100 is configured to measure the electrical energy/power consumed via the conductor 100. The utility meter 110 comprises any one of the current measurement systems 400, 600, 700, 800 or 900 described above. It further comprises a voltage measurement channel 1110, configured to measure the voltage of conductor 100 by any suitable means. The utility meter 1100 further optionally comprises an energy/power measurement unit 1120 (such as a circuit, or microcontroller, or programmable logics, etc) configured to determine the consumed energy/power based on the measured voltage and current. Optionally, the energy/power measurement unit 1120 may also be configured to have the functionality of the determination unit 620.

In all of the examples of the present disclosure, the signal processing circuitry includes an amplifier input stage and then an ADC. It should be appreciated that the input stage may be any suitable unit/circuit, for example an ADC such as a switched capacitor ADC, and the signal processing circuitry may include any additional or alternative units/circuits.

In all of the examples of the present disclosure, the current sensing coil is differential, but in an alternative it may be a single ended current sensing coil, and the signal processing circuit may be configured to measure a single ended signal output by the current sensing coil.

The skilled person will readily appreciate that various alterations or modifications may be made to the above described aspects of the disclosure without departing from the scope of the disclosure.

The terminology "coupled" used above encompasses both a direct electrical connection between two components, and an indirect electrical connection where the two components are electrically connected to each other via one or more intermediate components.

## **Aspects of the disclosure**

Non-limiting aspects of the disclosure are set out in the following numbered clauses:

### First set of temperature compensation clauses

1. A method of setting/compensating a temperature response of a current measurement system, wherein the current measurement system comprises:

> a current sensing coil for sensing a current in a conductor; and
> signal processing circuitry coupled to the current sensing coil for determining a measurement of the current in the conductor, the method comprising:
> setting/altering/modifying a temperature response of at least part of the signal processing circuitry based on at least one of:

>> a conductive track/trace impedance of the current sensing coil;
>> an input impedance of the signal processing circuitry to which the current sensing coil is coupled.

2. The method of clause 1, further comprising:

> determining a correction factor (CF) based on at least one of: the conductive track/trace impedance of the current sensing coil and/or the input impedance of the signal processing circuitry;
> wherein the temperature response of the at least part of the signal processing circuitry is set/altered/modified by the correction factor.

3. The method of any preceding clause, wherein setting/altering/modifying the temperature response of at least part of the signal processing circuitry is based on a determined ratio of the conductive track/trace impedance of the current sensing coil and the input impedance of the signal processing circuitry.

4. The method of any preceding clause, wherein at least one of the following is determined by applying a reference stimulation signal to the current measurement system:

> the conductive track/trace impedance of the current sensing coil;
> the input impedance of the signal processing circuitry to which the current sensing coil is coupled;
> a ratio of the conductive track/trace impedance of the current sensing coil and the input impedance of the signal processing circuitry.

5. The method of clause 4, wherein the reference stimulation signal is applied to the input of the signal processing circuitry.

6. The method of clause 4 or clause 5, wherein the signal processing circuit is further configured to extract from a measured signal a signal component that results from the reference stimulation signal.

7. The method of clause 6, wherein the measurement of current is based on the measured signal after removal of the signal component that results from the reference stimulation signal.

8. The method of clause 6 or clause 7, wherein setting/altering/modifying a temperature response is based on the reference stimulation signal and the extracted signal component that results from the reference stimulation signal.

9. The method of any of clauses 1 to 3, wherein at least one of the following is determined by applying a reference stimulation signal to a proxy structure relating to the coil track/track and/or a proxy structure relating to the input impedance of the signal processing circuitry:

the conductive track/trace resistance of the current sensing coil;
the input impedance of the signal processing circuitry to which the current sensing coil is coupled;
a ratio of the conductive track/trace resistance of the current sensing coil and the input impedance of the signal processing circuitry.

10. The method of any of clauses 4 to 9, wherein the reference stimulation signal is an AC signal

11. The method of clause 10, wherein the reference stimulation signal has a known frequency.

12. The method of any preceding clause, wherein setting/altering/modifying the temperature response is performed on power up of the current measurement system and/or intermittently or periodically during operation of the current measurement system and/or on request.

13. The method of any preceding clause, wherein the signal processing circuitry comprises an amplifier circuit coupled to the current sensing coil, or an ADC coupled to the current sensing coil.

14. The method of any preceding clause, further comprising detecting a failure or tamper of the current measurement system based on at least one of:

the conductive track/trace resistance of the current sensing coil;
the input impedance of the signal processing circuitry to which the current sensing coil is coupled;
a ratio of the conductive track/trace resistance of the current sensing coil and the input impedance of the signal processing circuitry.

15. A current measurement system comprising:

a current sensing coil comprising an opening suitable for a conductor to pass through, wherein the coil is suitable for sensing current in the conductor passing through the opening; and
signal processing circuitry coupled to the current sensing coil for determining a measurement of the current, wherein the system is configured to set/alter/modify a temperature response of at least part of the signal processing circuitry based on at least one of:

a conductive track/trace impedance of the current sensing coil;
an input impedance of the signal processing circuitry to which the current sensing coil is coupled.

16. The system of clause 15, further comprising a reference signal generator configured to generate a stimulation reference signal for use in determining any one or more of:

the conductive track/trace impedance of the current sensing coil;
the input impedance of the signal processing circuitry to which the current sensing coil is coupled;
a ratio of the conductive track/trace impedance of the current sensing coil and the input impedance of the signal processing circuitry.

Second set of temperature compensation clauses

1. A method of setting a temperature response of a current measurement system, wherein the current measurement system comprises:

a current sensing coil for sensing a current in a conductor; and

signal processing circuitry coupled to the current sensing coil for determining a measurement of the current in the conductor, the method comprising:

setting a temperature response of at least part of the signal processing circuitry based on at least one of:

an impedance of the current sensing coil;
an input impedance of the signal processing circuitry to which the current sensing coil is coupled;
a temperature dependent signal gain of the current measurement system.

2. The method of clause 1, further comprising:

determining a correction factor based on at least one of:

the impedance of the current sensing coil;
the input impedance of the signal processing circuitry; and

the temperature dependent signal gain of the current measurement system; andusing the correction factor to set the temperature response of the at least part of the signal processing circuitry.

3. The method of any preceding clause, further comprising determining the temperature dependent signal gain of the current measurement system by:

applying a known current to the conductor; and
determining the temperature dependent signal gain of the current measurement system based on at least a first measurement of the current in the conductor at a first temperature and a second measurement of the current in the conductor at a second temperature, wherein the first temperature and the second temperature are different.

4. The method of any preceding clause, wherein setting the temperature response of the at least part of the signal processing circuitry is based on a determined ratio of the impedance of the current sensing coil and the input impedance of the signal processing circuitry.

5. The method of any preceding clause, wherein the signal processing circuitry comprises an analog to digital converter, ADC, and wherein setting the temperature response of the signal processing circuitry comprises setting a reference voltage used by the ADC.

6. The method of any preceding clause, wherein the signal processing circuitry comprises a digital multiplier, and wherein setting the temperature response of the signal processing circuitry comprises setting a multiplication factor of the digital multiplier.

7. The method of any preceding clause, wherein at least one of the following is determined by applying a reference stimulation signal to the current measurement system:

the impedance of the current sensing coil;
the input impedance of the signal processing circuitry to which the current sensing coil is coupled;
a ratio of the impedance of the current sensing coil and the input impedance of the signal processing circuitry.

8. The method of clause 7, wherein the reference stimulation signal is applied to the input of the signal processing circuitry.

9. The method of clause 7 or clause 8, wherein the signal processing circuit is further configured to extract from a measured signal a signal component that results from the reference stimulation signal.

10. The method of clause 9, wherein the measurement of current is based on the measured signal after removal of the signal component that results from the reference stimulation signal.

11. The method of clause 9 or clause 10, wherein setting the temperature response of the at least part of the signal processing circuitry is based on the reference stimulation signal and the extracted signal component that results from the reference stimulation signal.

12. The method of any of clauses 1 to 6, wherein at least one of the following is determined by applying a reference stimulation signal to at least one of: a proxy structure relating to the current sensing coil; and a proxy structure relating to the input impedance of the signal processing circuitry:

the impedance of the current sensing coil;
the input impedance of the signal processing circuitry to which the current sensing coil is coupled;

a ratio of the impedance of the current sensing coil and the input impedance of the signal processing circuitry.

13. The method of any preceding clause, wherein setting the temperature response of the at least part of the signal processing circuitry is performed at at least one of the following times: during calibration of the current measurement system; on power up of the current measurement system; intermittently during operation of the current measurement system; periodically during operation of the current measurement system; on request.

14. The method of any preceding clause, further comprising detecting a failure or tamper of the current measurement system based on at least one of:

the impedance of the current sensing coil;
the input impedance of the signal processing circuitry to which the current sensing coil is coupled;
a ratio of the conductive track/trace resistance of the current sensing coil and the input impedance of the signal processing circuitry.

15. A current measurement system comprising:

a current sensing coil comprising an opening suitable for a conductor to pass through, wherein the coil is suitable for sensing current in the conductor passing through the opening; and
signal processing circuitry coupled to the current sensing coil for determining a measurement of the current, wherein the signal processing circuitry is configured for setting a temperature response of at least part of the signal processing circuitry based on at least one of:

an impedance of the current sensing coil;
an input impedance of the signal processing circuitry to which the current sensing coil is coupled;
a temperature dependency of a signal gain of the current measurement system.

16. The system of clause 15, further comprising a reference signal generator configured to generate a stimulation reference signal for use in determining any one or more of:

the impedance of the current sensing coil;
the input impedance of the signal processing circuitry to which the current sensing coil is coupled;
a ratio of the impedance of the current sensing coil and the input impedance of the signal processing circuitry.

17. The system of clause15 or clause 16, wherein the signal processing circuitry comprises an analog to digital converter, ADC, and wherein the system is configured for setting the temperature response of the signal processing circuitry by setting a reference voltage used by the ADC.

18. The system of any of clauses 15 to 17, wherein the signal processing circuitry comprises a digital multiplier, and wherein the system is configured for setting the temperature response of the signal processing circuitry by setting a multiplication factor of the digital multiplier.

19. Signal processing circuitry for use in measuring a current using a current sensing coil, the signal processing circuitry comprising:

one or more input terminals for coupling to a current sensing coil;
an analog to digital converter, ADC, for digitally converting an analog signal that is dependent on a signal at the one or more input terminals; and
a reference voltage circuit coupled to the ADC so as to supply a reference voltage to the ADC,
wherein the reference voltage circuit is configured to be trimable across a predetermined range of values so as to trim the reference voltage supplied to the ADC and set a temperature response of the signal processing circuitry, wherein the predetermined range of values is set to support a range of current sensing coil impedances.

20. The signal processing circuitry of clause 19, further comprising:

an amplifier comprising an input coupled to the one or more input terminals and configured to amplify the signal at the one or more input terminals,
wherein the ADC is configured to digitally convert an amplified signal output by the amplifier.

21. A utility meter comprising:

a volage measurement system configured to measure a voltage; and
a current measurement system configured to measure a current, wherein the current measurement system comprises:

a current sensing coil comprising an opening suitable for a conductor to pass through, wherein the coil is suitable for sensing current in the conductor passing through the opening; and
signal processing circuitry coupled to the current sensing coil for determining a measurement of the current,

wherein the signal processing circuitry is configured for setting a temperature response of at least part of the signal processing circuitry based on at least one of:

an impedance of the current sensing coil;
an input impedance of the signal processing circuitry to which the current sensing coil is coupled;
a temperature dependency of a signal gain of the current measurement system.

22. The utility meter of clause 21, wherein the signal processing circuitry comprises an analog to digital converter, ADC, and wherein setting the temperature response of the signal processing circuitry comprises setting a reference voltage used by the ADC.

23. The utility meter of clause 21 or clause 22, wherein the signal processing circuitry comprises a digital multiplier, and wherein setting the temperature response of the signal processing circuitry comprises setting a multiplication factor of the digital multiplier.

24. The utility meter of any of clauses 21 to 23, further configured to detecting a failure or tamper of the current measurement system based on at least one of:

the impedance of the current sensing coil;
the input impedance of the signal processing circuitry to which the current sensing coil is coupled;
a ratio of the conductive track/trace resistance of the current sensing coil and the input impedance of the signal processing circuitry.

Tamper and/or fault detection

1. A current measurement system comprising:

a current sensing coil for sensing current in a conductor passing through a central opening in the coil; and
signal processing circuitry coupled to output terminals of the current sensing coil for determining a measurement of current;
wherein the system is configured to apply a test signal to at least one of the current sensing coil output terminals such that determination of whether there is a fault/tamper of the system can be based on a common mode component in the signal processed by the signal processing circuitry whilst the test signal is applied.

2. The system of clause 1, wherein determination of whether there is a fault/tamper is based on a comparison of the common mode component in the signal processed by the signal processing circuitry against a reference common mode offset.

3. The system of clause 2, wherein the reference common mode offset is a value that was measured in the signal processed by the signal processing circuitry while the test signal is applied at a reference time (such as during manufacture or calibration).

4. The system of any preceding clause, further comprising:
a first load (R1a) coupled to a first output terminal of the current sensing coil, for applying a first signal to the first output terminal.

5. The system of clause 4, further comprising:
a second load (R1b) coupled to a second output terminal of the current sensing coil, for applying a second signal to the second output terminal.

6. The system of clause 5, wherein the first load and the second load have the same impedance so that if there is no fault or tamper in the system, there should be little or no DC offset in the signal processed by the signal processing circuitry.

7. The system of clause 6, wherein the first load and the second load have different impedances so that if there is no fault or tamper in the system, there should be a reference common mode offset in the signal processed by the signal processing circuitry.

8. The system of clause 7, wherein determination of whether there is a fault/tamper is based on a comparison of the reference common mode offset and a measurement of the common mode in the signal processed by the signal processing circuitry.

9. The system of clause 7 or clause 8, wherein the reference common mode offset is determined by measuring a common mode offset in the signal processed by the signal processing circuitry while the test signal is applied at a reference time (such as during manufacture or calibration).

10. The system of any of clauses 4 to 9, wherein a first terminal of the first load is coupled to the first output terminal of the current sensing coil, and a second terminal of the first load is for coupling to a common mode voltage of the current sensing coil, so as to generate the first signal in dependence on the common mode of the current sensing coil.

11. The system of any preceding clause, further configured to switchably apply the test signal to the at least one of current sensing coil output terminals.

12. The system of any preceding clause, wherein the test signal is a DC test signal

13. A method for detecting a fault/tamper in a current measurement system, the method comprising:

applying a test signal to at least one output terminal of a current sensing coil of the current measurement system; and

determine whether there is a fault/tamper based on a common mode component in a signal that is processed by signal processing circuitry coupled to the output terminals of the current sensing coil.

14. The method of clause 13, wherein determining whether there is a fault/tamper comprises:

comparing a measure of the common mode component against a reference common mode offset, wherein, a difference between the measure of the common mode component and the reference common mode offset is greater than a threshold amount, then a fault/tamper is detected.

15. The method of clause 14, wherein the reference common mode offset is a non-zero value.

16. The method of any of clauses 13 to 15, wherein applying the test signal comprises controlling one or more switches to apply or disapply the test signal.

17. The method of any of clauses 13 to 16, further comprising, if a fault/tamper is detected, perform at least one of:

disconnection of a utility supply;
cause an audio indication of fault/tamper;
cause a visual indication of fault/tamper;
output a fault/tamper message to a remote device/entity.

18. The method of any of clauses 13 to 17, wherein the test signal is a DC test signal.

19. A utility meter comprising the system of any of clauses 1 to 12.

## Claims

1. A method of setting a temperature response of a current measurement system, wherein the current measurement system comprises:

a current sensing coil for sensing a current in a conductor; and
signal processing circuitry coupled to the current sensing coil for determining a measurement of the current in the conductor, the method comprising:
setting a temperature response of at least part of the signal processing circuitry based on at least one of:

an impedance of the current sensing coil;
an input impedance of the signal processing circuitry to which the current sensing coil is coupled;
a temperature dependent signal gain of the current measurement system.

2. The method of claim 1, further comprising:

determining a correction factor based on at least one of:

the impedance of the current sensing coil;
the input impedance of the signal processing circuitry; and

the temperature dependent signal gain of the current measurement system; and
using the correction factor to set the temperature response of the at least part of the signal processing circuitry.

3. The method of any preceding claim, further comprising determining the temperature dependent signal gain of the current measurement system by:

applying a known current to the conductor; and
determining the temperature dependent signal gain of the current measurement system based on at least a first measurement of the current in the conductor at a first temperature and a second measurement of the current in the conductor at a second temperature, wherein the first temperature and the second temperature are different.

4. The method of any preceding claim, wherein setting the temperature response of the at least part of the signal processing circuitry is based on a determined ratio of the impedance of the current sensing coil and the input impedance of the signal processing circuitry.

5. The method of any preceding claim, wherein the signal processing circuitry comprises an analog to digital converter, ADC, and wherein setting the temperature response of the signal processing circuitry comprises setting a reference voltage used by the ADC.

6. The method of any preceding claim, wherein the signal processing circuitry comprises a digital multiplier, and wherein setting the temperature response of the signal processing circuitry comprises setting a multiplication factor of the digital multiplier.

7. The method of any preceding claim, wherein at least one of the following is determined by applying a reference stimulation signal to the current measurement system:

the impedance of the current sensing coil;
the input impedance of the signal processing circuitry to which the current sensing coil is coupled;
a ratio of the impedance of the current sensing coil and the input impedance of the signal processing circuitry.

8. The method of claim 7, wherein the signal processing circuit is further configured to extract from a measured signal a signal component that results from the reference stimulation signal.

9. The method of claim 7 or claim 8, wherein setting the temperature response of the at least part of the signal processing circuitry is based on the reference stimulation signal and the extracted signal component that results from the reference stimulation signal.

10. The method of any of claims 1 to 6, wherein at least one of the following is determined by applying a reference stimulation signal to at least one of: a proxy structure relating to the current sensing coil; and a proxy structure relating to the input impedance of the signal processing circuitry:

the impedance of the current sensing coil;
the input impedance of the signal processing circuitry to which the current sensing coil is coupled;
a ratio of the impedance of the current sensing coil and the input impedance of the signal processing circuitry.

11. The method of any preceding claim, wherein setting the temperature response of the at least part of the signal processing circuitry is performed at at least one of the following times: during calibration of the current measurement system; on power up of the current measurement system; intermittently during operation of the current measurement system; periodically during operation of the current measurement system; on request.

12. The method of any preceding claim, further comprising detecting a failure or tamper of the current measurement system based on at least one of:

the impedance of the current sensing coil;
the input impedance of the signal processing circuitry to which the current sensing coil is coupled;

a ratio of the conductive track/trace resistance of the current sensing coil and the input impedance of the signal processing circuitry.

13. A current measurement system comprising:

a current sensing coil comprising an opening suitable for a conductor to pass through, wherein the coil is suitable for sensing current in the conductor passing through the opening; and
signal processing circuitry coupled to the current sensing coil for determining a measurement of the current, wherein the signal processing circuitry is configured for setting a temperature response of at least part of the signal processing circuitry based on at least one of:

an impedance of the current sensing coil;
an input impedance of the signal processing circuitry to which the current sensing coil is coupled;
a temperature dependency of a signal gain of the current measurement system.

14. The system of claim 13, further comprising a reference signal generator configured to generate a stimulation reference signal for use in determining any one or more of:

the impedance of the current sensing coil;
the input impedance of the signal processing circuitry to which the current sensing coil is coupled;
a ratio of the impedance of the current sensing coil and the input impedance of the signal processing circuitry.

15. The system of claim 13 or claim 14, wherein the signal processing circuitry comprises an analog to digital converter, ADC, and wherein the system is configured for setting the temperature response of the signal processing circuitry by setting a reference voltage used by the ADC.

EP 4 715 399 A1

Figure 1

Figure 2b

Figure 2a

$V_{trace}$

$V_{amp}$

$R_{trace}$
$(+\alpha_{trace}\ ppm/^\circ C)$

$R_{amp}$
$(+\alpha_{amp}\ ppm/^\circ C)$

$V_{coil}$

Figure 3

Figure 4

```
┌─────────────────┐
│                 │
│      S510       │
│                 │
└─────────────────┘
         │
         ▼
┌─────────────────┐
│                 │
│      S520       │
│                 │
└─────────────────┘
         │
         ▼
┌─────────────────┐
│                 │
│      S530       │
│                 │
└─────────────────┘
```

# Figure 5

Differential Coil biased to Vcm

600

620

ADC 430

$V_{out}$

$R_{fb}$

$R_{fb}$

410

$R_{ampa}$

$R_{ampb}$

A

B

$R_{1a}$

$R_{1b}$

$R_{tracea}$

$R_{traceb}$

102

$V_{cm}$

610

Figure 6A

Figure 6B

Figure 7

EP 4 715 399 A1

Figure 8

EP 4 715 399 A1

Figure 9

EP 4 715 399 A1

Figure 10

Figure 11

# EUROPEAN SEARCH REPORT

**Application Number**

EP 25 20 3757

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/356935 A1 (HURWITZ JONATHAN EPHRAIM DAVID [GB]) 14 December 2017 (2017-12-14) | 1-11, 13-15 | INV. G01R15/18 G01R19/32 |
| A | * paragraphs [0027] - [0029], [0142], [0152] - [0178]; figure 36 * ----- | 12 | |
| A | US 2015/015244 A1 (RAY WILLIAM FREDERICK [GB] ET AL) 15 January 2015 (2015-01-15) * the whole document * ----- | 1-15 | |
| A | US 2019/310289 A1 (MILLER THEODORE JAMES [US]) 10 October 2019 (2019-10-10) * the whole document * ----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 5 February 2026 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 3757

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2026

| Patent document cited in search report | Publication date | Patent family member(s) | | Publication date |
|---|---|---|---|---|
| US 2017356935 A1 | 14-12-2017 | US | 2017356935 A1 | 14-12-2017 |
| | | WO | 2017211599 A1 | 14-12-2017 |
| US 2015015244 A1 | 15-01-2015 | CN | 104094125 A | 08-10-2014 |
| | | EP | 2810088 A1 | 10-12-2014 |
| | | ES | 2709100 T3 | 15-04-2019 |
| | | KR | 20140123567 A | 22-10-2014 |
| | | PL | 2810088 T3 | 28-06-2019 |
| | | US | 2015015244 A1 | 15-01-2015 |
| | | WO | 2013114137 A1 | 08-08-2013 |
| US 2019310289 A1 | 10-10-2019 | CN | 111936868 A | 13-11-2020 |
| | | EP | 3775938 A1 | 17-02-2021 |
| | | US | 2019310289 A1 | 10-10-2019 |
| | | WO | 2019192757 A1 | 10-10-2019 |

EPO FORM P0459

For more details about this annex : see Official Journal of the European Patent Office, No. 12/82